(19) **Europäisches Patentamt**

**European Patent Office**

**Office européen des brevets**

(11) **EP 0 860 944 B1**

(12) **FASCICULE DE BREVET EUROPEEN**

(45) Date de publication et mention
de la délivrance du brevet:
**16.07.2003 Bulletin 2003/29**

(51) Int Cl.⁷: **H03H 21/00**

(21) Numéro de dépôt: **98200391.5**

(22) Date de dépôt: **09.02.1998**

(54) **Système de séparation de sources non stationnaires.**

Trennvorrichtung für nicht-stationäre Quellen

Separation system for non-stationary sources

(84) Etats contractants désignés:
**DE FR GB**

(30) Priorité: **18.02.1997 FR 9701881**

(43) Date de publication de la demande:
**26.08.1998 Bulletin 1998/35**

(73) Titulaire: **Koninklijke Philips Electronics N.V.
5621 BA Eindhoven (NL)**

(72) Inventeur: **Deville, Yannick
75008 Paris (FR)**

(74) Mandataire: **Charpail, François et al
Société Civile S.P.I.D.
156, Boulevard Haussmann
75008 Paris (FR)**

(56) Documents cités:
**EP-A- 0 565 479**

• **NAJAR M ET AL: "BLIND WIDEBAND SOURCE SEPARATION" PROCEEDINGS OF THE INTERNATIONAL CONFERENCE ON ACOUSTICS, SPEECH AN SIGNAL PROCESSING (ICASSP), S. STATISTICAL SIGNAL AND ARRAY PROCESSING ADELAIDE, APR. 19 - 22, 1994, vol. 4, 19 avril 1994, INSTITUTE OF ELECTRICAL AND ELECTRONICS ENGINEERS, pages IV-65-IV-68, XP000530548**

**Description**

L'invention concerne un système de séparation de sources pour traiter des signaux d'entrée formés par des mélanges de signaux primaires issus des sources et pour estimer les signaux primaires, le système comprenant un premier sous-ensemble de séparation de sources qui, à l'aide de coefficients de séparation délivre des estimations des signaux primaires, un second sous-ensemble déterminant adaptativement les coefficients de séparation.

Il existe des systèmes qui reçoivent sur leurs entrées des signaux qui se présentent sous la forme de signaux de mélange formés par une superposition de contributions résultant de plusieurs signaux sources. Ceci se présente par exemple avec une antenne qui reçoit des signaux provenant de plusieurs émetteurs, ou quand un microphone délivre un signal de parole désiré mélangé à des signaux perturbateurs non désirés. Généralement on désire extraire tous les signaux de source présents dans le mélange, soit parfaitement soit en optimisant un rapport signal/bruit.

En utilisant plusieurs capteurs délivrant plusieurs signaux de mélange, on a cherché à obtenir des estimations fiables des signaux de sources. Des techniques connues opèrent avec des signaux de mélange inconnus et avec des signaux de sources inconnus de sorte que les techniques de séparation sont appelées techniques de séparation en aveugle de sources.

Parmi les structures de séparation de sources connues, on peut par exemple citer le document d'art antérieur "Multi-layer neural networks with a local adaptive learning rule for blind separation of source signais", A. CICHOCKI, W. KASPRZAK, S. AMARI, International Symposium on nonlinear theory and its applications (NOLTA'95) LAS VEGAS, Décembre 10-14, 1995, 1C-5, pages 61 à 65.

Ce document concerne des mélanges difficiles à traiter par exemple parce que les signaux de mélange sont très semblables les uns aux autres ou lorsque les signaux de mélange ont des niveaux très différents.

Néanmoins les structures décrites dans ce document ne conviennent pas lorsque les signaux de sources sont des signaux non stationnaires. Ceci constitue un inconvénient important, car ces types de signaux se rencontrent très souvent dans les applications concrètes telles que le traitement des signaux de paroles ou plus généralement des signaux audio.

Le but de l'invention est de proposer un système de séparation de source qui permette de traiter le cas des signaux non stationnaires même si ces signaux entrent dans la catégorie des mélanges dits difficiles cités précédemment.

Ce but est atteint avec un système de séparation de sources pour traiter des signaux d'entrée formés par des mélanges de signaux primaires issus des sources et pour estimer les signaux primaires, le système comprenant un premier sous-ensemble de séparation de sources ayant des premières entrées reliées aux signaux d'entrée, des secondes entrées pour recevoir des coefficients de séparation et des sorties pour délivrer des premières estimations des signaux primaires, un second sous-ensemble pour déterminer adaptativement les coefficients de séparation caractérisé en ce qu'il comprend un troisième sous-ensemble qui reçoit les premières estimations parmi lesquelles il détecte une estimation maximale possédant un niveau d'amplitude maximal et qui normalise les premières estimations par rapport à l'estimation maximale pour délivrer des secondes estimations lesquelles entrent dans le second sous-ensemble pour le calcul des coefficients de séparation.

Ainsi lorsque les signaux primaires issus des sources présentent de fortes variations de niveaux d'amplitude au cours d'une période transitoire, il ne peut pas se produire un dépassement temporaire du niveau d'amplitude des secondes estimations pendant cette période transitoire. Le niveau des secondes estimations reste toujours contenu dans une fenêtre d'amplitude déterminée.

Cependant, quand le niveau du signal d'entrée est relativement constant, qu'il soit fort ou faible, les premières estimations qui sont délivrées en sortie présentent un niveau moyen sensiblement semblable en sortie. Ceci signifie que les coefficients de séparation calculés par le système s'adaptent de manière à maintenir les premières estimations délivrées normalisées avec une énergie prédéfinie. Ceci peut constituer un handicap dans certaines applications car on perd ainsi le caractère fort ou faible d'un signal d'entrée. Par exemple dans le cas de signaux de parole, il peut être utile de différencier une voix faible d'une voix forte.

Pour corriger cet inconvénient, selon l'invention, le troisième sous-ensemble comporte un module de sortie qui divise chaque première estimation par un coefficient de séparation spécifique pour délivrer des troisièmes estimations proportionnelles aux signaux primaires avec un facteur de proportionnalité indépendant desdits signaux primaires.

Dans certaines applications particulières, il peut apparaître qu'un signal primaire soit temporairement absent. La situation qui mérite de l'attention est celle de locuteurs s'exprimant alternativement. Il existe donc des moments durant lesquels chaque interlocuteur s'arrête de parler, c'est-à-dire que son signal source est momentanément interrompu pour reprendre quelques instants plus tard. Il faut donc que l'estimation de ce signal absent soit nulle en sortie durant ces périodes. Or dans le cas de signaux primaires nuls ou très faibles, le système de séparation aura tendance à dupliquer sur la sortie inutilisée une des autres estimations non nulles. Pour éviter cette situation, selon l'invention, on munit le troisième sous-ensemble d'un module de sélection qui empêche à une estimation d'être dupliquée sur une voie affectée à un signal primaire absent.

Ces différents aspects de l'invention et d'autres encore seront apparents et élucidés à partir des modes de réalisation décrits ci-après.

L'invention sera mieux comprise à l'aide des figures suivantes données à titre d'exemples non limitatifs qui représentent:

> Figure 1 : Un schéma général d'un système de séparation de sources.
> Figure 2 : Un schéma particulier d'un système de séparation selon l'art antérieur pour séparer deux signaux d'entrée.
> Figure 3 : Des allures d'un signal d'entrée présentant de fortes variations de niveau.
> Figure 4 : Un schéma général d'un système de séparation de sources selon l'art antérieur.
> Figure 5 : Un schéma général d'un système de séparation de sources selon l'invention.
> Figure 6 : Un schéma de séparation de sources selon l'invention permettant aux estimations de ne pas diverger en sortie.
> Figure 7 : Un schéma de séparation de sources selon l'invention permettant aux estimations de ne pas diverger et de rester proportionnées aux signaux d'entrée.
> Figure 8 : Un schéma d'un système de séparation de sources selon l'invention permettant aux estimations de ne pas diverger, de rester proportionnées aux signaux d'entrée et empêchant à une estimation d'être dupliquée sur une voie affectée à un signal primaire absent.
> Figure 9 : Un schéma d'un exemple particulier avec deux signaux d'entrée dans le cas de la figure 8.

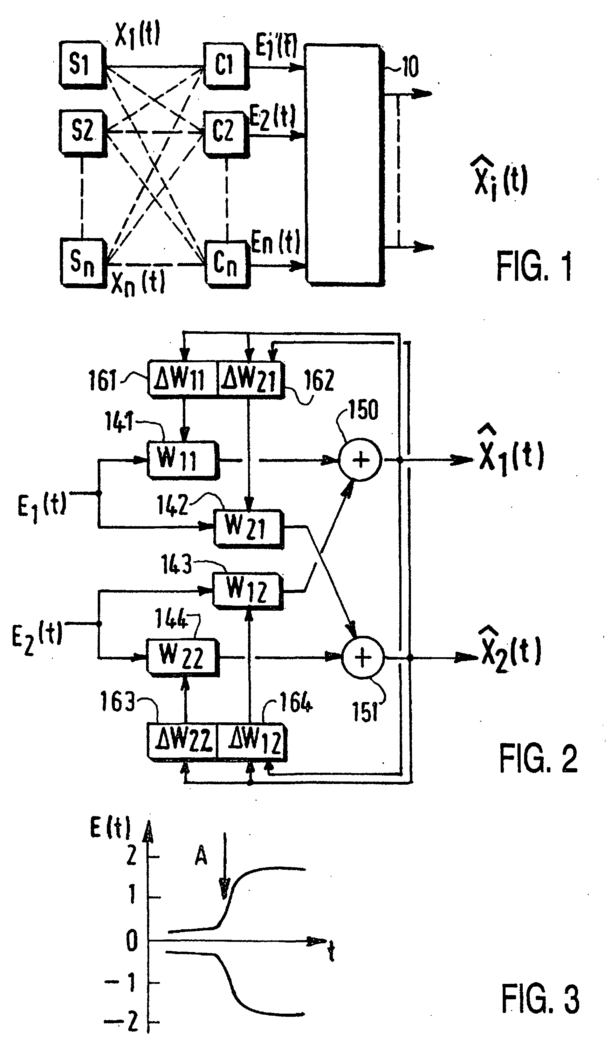

La figure 1 représente des sources primaires Si à Sn constituées par exemple par des voix de passagers dans un véhicule, par des sources de bruits divers (moteur, carrosserie, circulation d'air par les fenêtres, etc) et par un autoradio. Les sources primaires délivrent des signaux primaires $X_i(t)$. On observe que ces signaux primaires vont se mélanger les uns aux autres dans l'espace de transmission. Pour identifier les voix, on place des capteurs C1 à Cn, par exemple des microphones, à l'intérieur de l'habitacle. Les capteurs délivrent des signaux de mélange $E_i(t)$.

De manière analogue, cela peut concerner la réception d'ondes hertziennes émises par des sources Si à Sn et détectées par des capteurs constitués par des antennes C1 à Cn. Dans l'air, les signaux primaires $X_i(t)$ délivrés par les émetteurs vont arriver mélangés les uns aux autres au niveau des antennes. Celles-ci vont alors fournir des signaux de mélange $E_i(t)$ qui sont les seuls signaux accessibles au niveau de la réception. Pour obtenir des signaux estimés, dits estimations $X_i(t)$, i indice courant variant de 1 à n, correspondant à chaque source, à partir des signaux de mélange $E_i(t)$, il est connu d'utiliser un système 10 de séparation de sources.

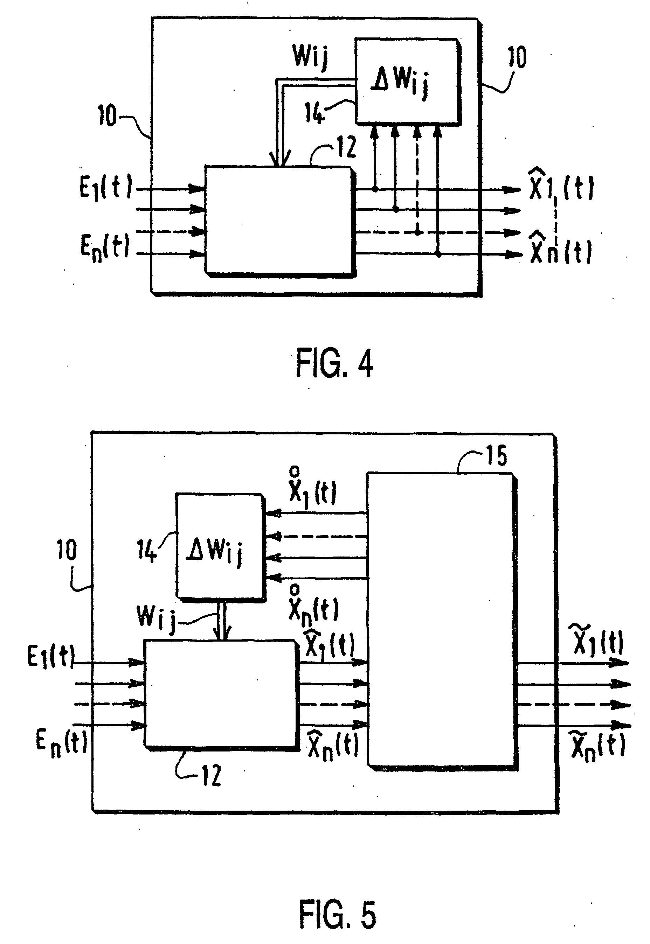

Selon l'art antérieur connu (figure 4). les signaux d'entrée $E_i(t)$ entrent dans un sous-ensemble 12 de séparation de sources qui délivre des premières estimations $X_i(t)$. Un second sous-ensemble 14 détermine des coefficients de séparation $W_{i,j}$ à partir des premières estimations $X_i(t)$. Pour cela il calcule des facteurs de correction $\Delta W_{i,j}$ pour mettre à jour les coefficients de séparation. Ceux-ci sont alors introduits au cycle suivant dans le premier sous-ensemble 12 pour la détermination des estimations suivantes $X_i(t)$.

Pour des raisons de clarté on va décrire un cas simple d'un système à structure directe comportant une seule couche de traitement pour séparer deux signaux de sources $X_1(t)$ et $X_2(t)$ selon l'art antérieur cité (figure 2). Deux capteurs délivrent des signaux de mélange $E_1(t)$ et $E_2(t)$. Ces signaux sont reliés aux signaux primaires par les relations suivantes:

$$(1) \qquad E_1(t) = a_{11}X_1(t) + a_{12}X_2(t)$$

$$(2) \qquad E_2(t) = a_{21}X_1(t) + a_{22}X_2(t)$$

dans lesquelles les termes $a_{11}$, $a_{12}$, $a_{21}$, $a_{22}$ sont des coefficients de mélanges inconnus. Les signaux qui figurent dans ces relations sont des signaux centrés c'est-à-dire que les composantes continues qui pourraient y figurer ont été éliminées par exemple par une opération de filtrage appropriée.

Le schéma de l'art antérieur représenté sur la figure 2 permet de déterminer les estimations $X_1(t)$ et $X_2(t)$ à partir des signaux de mélange $E_1(t)$ et $E_2(t)$ à partir des relations:

$$(3) \qquad \overset{\wedge}{X}_1(t) = W_{11}E_1(t) + W_{12}E_2(t)$$

$$(4) \qquad \overset{\wedge}{X}_2(t) = W_{21}E_1(t) + W_{22}E_2(t)$$

dans lesquelles les termes $W_{11}$, $W_{12}$, $W_{21}$, $W_{22}$ sont des coefficients de séparation adaptatifs.

Pour mettre à jour les coefficients de séparation, on peut appliquer les règles d'adaptation suivantes:

$$(5) \qquad W_{ii}(t+1) = W_{ii}(t) - \mu\{f[\overset{\wedge}{X}_i(t)]g[\overset{\wedge}{X}_i(t)]-1\}$$

$$(6) \qquad W_{ij}(t+1) = W_{ij}(t) - \mu f[\overset{\wedge}{X}_i(t)]g[\overset{\wedge}{X}_j(t)], \ i{\neq}j$$

dans laquelle $\mu$ est un pas positif d'adaptation, f et g étant des fonctions de préférence non linéaires. En particulier, on peut choisir $f(x)=x^3$ et $g(x)=x$. Sur la figure 4, les signaux $X_1(t)$ et $X_2(t)$ arrivent dans le sous-ensemble 14 qui calcule les facteurs de correction $\Delta W_{ij}$ à fournir aux coefficients $W_{ij}$ entre les instants t et t+1, d'après les relations:

$$(7) \qquad \Delta W_{ii} = W_{ii}(t+1) - W_{ii}(t) = -\mu\{f[\hat{X}_i(t)]g[\hat{X}_i(t)] - 1\}$$

$$(8) \qquad \Delta W_{ij} = W_{ij}(t+1) - W_{ij}(t) = -\mu f[\hat{X}_i(t)]g[\hat{X}_j(t)], \; i \neq j$$

Les nouvelles valeurs de $W_{ij}$ sont chargées dans des mémoires de coefficients de séparation contenues dans le premier sous-ensemble 12.

La règle d'adaptation (6) est utilisée pour mettre à jour les coefficients croisés $W_{12}$ et $W_{21}$ visant à éliminer la composante $X_2(t)$ dans $X_1(t)$ et la composante $X_1(t)$ dans $X_2(t)$.

La règle d'adaptation (5) est utilisée pour mettre à jour les coefficients directs $W_{11}$ et $W_{22}$ visant à normaliser les échelles des signaux $X_1(t)$ et $X_2(t)$ respectivement. Ces coefficients directs s'adaptent eux-mêmes à la nature des signaux à traiter.

Dans le cas de deux signaux représenté sur la figure 2, le signal de mélange $E_1(t)$ entre dans des multiplieurs 141, 142 et le signal de mélange $E_2(t)$ entre dans des multiplieurs 143, 144. Les sorties des multiplieurs 141 et 143 sont additionnées dans un additionneur 150 tandis que les sorties des multiplieurs 142 et 144 sont additionnées dans un additionneur 151 pour délivrer respectivement les estimations $X_1(t)$ et $X_2(t)$. Le module 161 reçoit l'estimation $X_1(t)$ et le module 162 reçoit les estimations $X_1(t)$ et $X_2(t)$. Les modules 161 et 162 calculent respectivement les facteurs de correction $\Delta W_{11}$ et $\Delta W_{21}$ selon les équations 7 et 8 et délivrent dès coefficients de séparation mis à jour $W_{11}$ et $W_{21}$. Un traitement analogue est effectué dans les modules 163 et 164 pour les facteurs de correction $\Delta W_{12}$ et $\Delta W_{22}$.

Considérons le cas de signaux de sources ayant une échelle relativement constante (ou une enveloppe constante) durant une période donnée, les coefficients de mélange $a_{ij}$ étant par ailleurs constants ou très lentement variables. Dans ce cas les coefficients $W_{11}$ et $W_{22}$ convergent vers des valeurs relativement constantes assurant des énergies prédéfinies aux estimations $X_1(t)$ et $X_2(t)$. Dans le cas où $f(x)=x^3$ et $g(x)=x$, l'énergie prédéfinie s'exprime par $<X^4>$. Cette valeur prédéfinie est par exemple égale à 1 dans le cas des équations 5 et 6. La remise à jour des coefficients de séparation est effectuée à chaque unité de temps t, t+1, t+2...

Lorsque l'échelle des signaux de sources varie brusquement très fortement ceci provoque une variation rapide et forte des signaux de mélange. Ce cas est représenté sur la figure 3. Au point A, il y a une brusque variation dans l'enveloppe des signaux de mélange E(t). Néanmoins aux instants immédiatement suivants, d'après l'algorithme de mise à jour précédent, les coefficients de séparation $W_{11}$ et $W_{22}$ vont conserver des valeurs proches de celles qu'ils avaient juste avant cette forte augmentation car leur adaptation nécessite une durée s'étalant sur quelques centaines à quelques milliers d'unités de temps. Donc la forte augmentation d'échelle des signaux de mélange provoque aussi une forte augmentation des estimations $X_1(t)$ et $X_2(t)$ par les relations (3) et (4) qui à son tour entraîne que les modifications des coefficients $W_{11}$ et $W_{22}$ deviennent élevées à cause de la relation (5). Ainsi les valeurs de ces coefficients de séparation deviennent très élevées d'où un fort accroissement des signaux de sortie occasionnant un nouvel accroissement des coefficients de séparation faisant que les sorties peuvent diverger dans le cas des signaux non stationnaires.

L'invention consiste à modifier le système de l'art antérieur représenté sur la figure 4, à conserver les opérations (3) et (4) mais à modifier les règles d'adaptation des coefficients de séparation. Plus précisément, au lieu d'utiliser les premières estimations $X_1(t)$ et $X_2(t)$ pour mettre à jour les coefficients, on fait passer ces signaux dans des moyens spécifiques qui limitent leurs amplitudes d'après l'instant considéré. Ce sont des secondes estimations à amplitudes limitées qui sont alors utilisées. Ainsi les modifications fournies aux coefficients de séparation sont bornées. De cette manière, les nouveaux coefficients convergent progressivement vers de nouvelles valeurs stables et ne divergent plus.

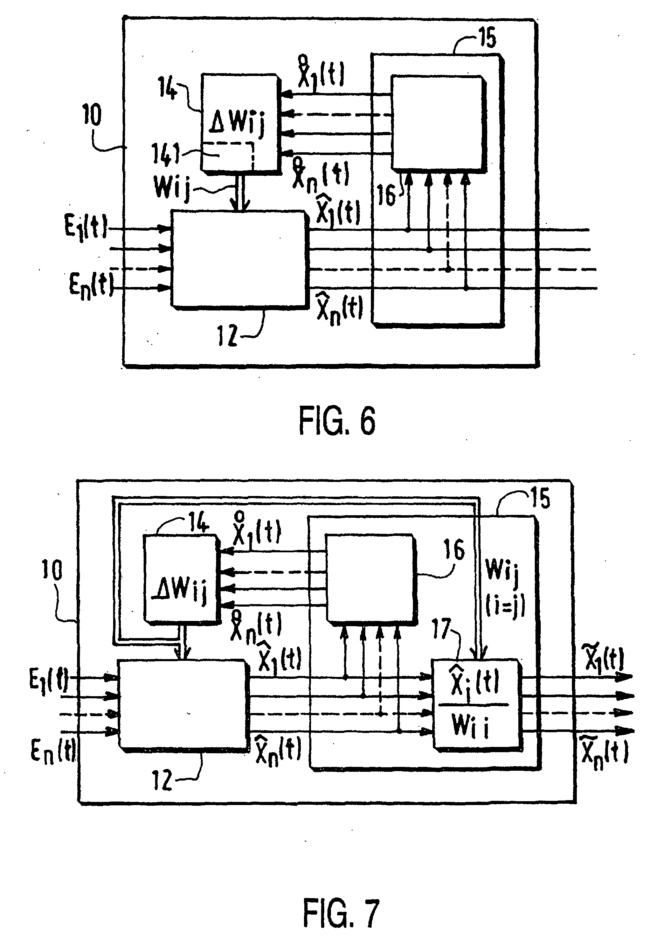

Ce mode de réalisation est représenté sur les figures 5 et 6. Un troisième sous-ensemble 15 est placé en sortie du premier sous-ensemble 12. Le troisième sous-ensemble transforme les premières estimations $X_1(t)$ à $X_n(t)$ en des secondes estimations $\dot{X}_1(t)$ à $\dot{X}_n(t)$ dont les amplitudes sont normalisées par rapport au signal ayant l'amplitude maximale, en valeur absolue, pris parmi ceux compris dans $X_1(t)$ à $X_n(t)$ à l'instant considéré. Cette opération est réalisée dans une unité 16 de limitation d'amplitude (figure 6).

A chaque instant, on modifie les coefficients de séparation de la manière suivante:

- on calcule les sorties $\hat{X}_i(t)$ du système de l'art antérieur;
- on calcule le maximum M de leurs valeurs absolues soit: $M = \max|\hat{X}_i(t)|$, $i=1...n$;
- on définit une valeur de seuil $\beta>0$ correspondant à la valeur maximale autorisée pour les valeurs absolues des signaux limités $\dot{X}_i(t)$. Ce seuil est choisi librement et définit l'ampleur de la limitation désirée.

A l'instant considéré, on compare M à $\beta$ et on réalise la limitation telle que:

- si M <=$\beta$, les signaux $\hat{X}_i(t)$ ont une amplitude assez faible, donc il n'y a pas lieu de limiter, d'où:

$$\forall i=1...n, \; \dot{X}_i(t) = \hat{X}_i(t);$$

- si M>$\beta$, au moins un signal a une amplitude forte, donc on limite tous les signaux avec le même facteur de réduction, d'où:

$$\forall i=1...n, \ \dot{X}_i(t)=\beta\frac{\hat{X}_i(t)}{M}.$$

Les variations $\Delta W_{ij}$ sont calculées de la même façon que dans le système de l'art antérieur. Le second sous-ensemble 14 détermine les modifications à apporter aux coefficients de séparation $W_{ij}$ à partir des secondes estimations $\dot{X}_1(t)$ à $\dot{X}_n(t)$ c'est-à-dire:

$$(9) \qquad \Delta W_{ii}=-\mu\{f[\dot{X}_i(t)]g[\dot{X}_i(t)]-1\}$$

$$(10) \qquad \Delta W_{ij}=-\mu f[\dot{X}_i(t)]g[\dot{X}_j(t)], \ i\neq j.$$

L'invention peut être également appliquée (module 12) à une structure de séparation de sources décrite dans le document: "Blind separation of sources, Part I: An adaptive algorithm based on neuromimetic architecture" C.JUTTEN, J. HERAULT, Signal Processing, 24, 1991, pages 1-10.

Une seconde possibilité permettant de limiter la divergence des signaux de sortie consiste à calculer les facteurs de correction:

$$(11) \qquad F_{ij}(t)=-\mu\{f[\hat{X}_i(t)]g[\hat{X}_i(t)]-1\}, \ i=j$$

$$(12) \qquad F_{ij}(t)=-\mu f[\hat{X}_i(t)]g[\hat{X}_j(t)], \ i\neq j$$

mais au lieu d'utiliser ces facteurs de correction tels quels pour mettre à jour les coefficients de séparation, on fait passer les signaux correspondant à ces facteurs de correction dans des moyens de filtrage passe-bas de manière à adoucir l'évolution de ces variations. Ceci évite des changements brusques d'échelle. Cette solution s'avère moins robuste que la précédente. Préférentiellement on l'associe à la première solution et dans ce cas le second sous-ensemble 14 comporte une unité de filtrage passe-bas 141 qui filtre les facteurs de correction $F_{ij}(t)$ pour calculer les variations de coefficients $\Delta W_{ij}$ pour mettre à jour les coefficients de séparation $W_{ij}$.

Dans ce cas, chaque coefficient de séparation est modifié d'une quantité $\Delta W_{ij}(t)$ qui résulte d'un filtrage passe-bas d'ordre 1 c'est-à-dire:

$$\Delta W_{ij}(t)=\frac{F_{ij}(t)+\alpha\Delta W_{ij}(t\text{-}1)}{1+\alpha}$$

ce qui peut aussi être exprimé par:

$$W_{ij}(t+1)=W_{ij}(t)+\frac{F_{ij}(t+1)+\alpha(W_{ij}(t)-W_{ij}(t\text{-}1))}{1+\alpha}$$

où $\alpha>0$ est un paramètre du filtre définissant l'amplitude de l'effet de lisage apporté par le filtre. Ce paramètre est prédéterminé.

L'opération de normalisation en énergie réalisée sur les premières estimations délivrées par le premier sous-ensemble a pour conséquence de maintenir ces premières estimations voisines d'une énergie prédéfinie, et ceci quelle que soit l'échelle des signaux de sources. Les premières estimations vont donc converger vers une même énergie normalisée. Ceci n'est pas toujours acceptable dans toutes les applications où apparaissent des signaux de source non stationnaires. Par exemple, considérons le cas où les signaux de source sont des signaux de paroles avec des périodes durant lesquelles les signaux possèdent une énergie élevée (paroles fortes) et des périodes durant lesquelles les signaux possèdent une énergie faible (paroles faibles). Dans la situation décrite précédemment, les premières estimations auraient toutes la même énergie élevée dans ces deux situations ce qui revient à faire un nivellement d'énergie.

Pour remédier à cet effet, selon l'invention (figure 7) on réalise un post-traitement sur les premières estimations $\hat{X}_i(t)$. Pour cela chaque première estimation $\hat{X}_i(t)$ de rang i est divisée par le coefficient de séparation $W_{ii}$ correspondant à son rang, apparaissant dans les équations 3 et 4. Ceci s'apparente à une dénormalisation ou à un contrôle auto-adaptatif du gain. On observe aisément que les troisièmes estimations $\tilde{x}_i(t)=\hat{X}_i(t)/W_{ii}$ ainsi obtenues sont proportionnelles aux signaux de sources correspondant $X_i(t)$ avec un facteur de proportionnalité constant. Cette opération est réalisée dans le module de sortie 17 représenté sur la figure 7.

Donc les étapes du traitement consistent d'abord à multiplier les signaux de mélange par les coefficients de séparation $W_{ij}$ puis à délivrer les premières estimations normalisées $\hat{X}_i(t)$ et ensuite à les diviser par les mêmes coefficients de séparation $W_{ii}$ pour obtenir des troisièmes estimations dénormalisées $\tilde{x}_i(t)=\hat{X}_i(t)/W_{ii}$. Il faut remarquer que ces opérations ne sont pas redondantes et ne s'annulent pas.

Un autre mode particulier de réalisation de l'invention concerne le cas de deux signaux non stationnaires pour lesquels il n'existe, pendant une période donnée, qu'un seul signal de source $X_i(t)$ non nul ou plus particulièrement lorsqu'avec deux signaux de sources, un des signaux est très élevé par rapport à l'autre. Dans ce cas ce signal de source fort va donner lieu à une estimation (première ou seconde selon le cas) qui va apparaître sur les deux voies de sortie du dispositif selon les modes de réalisation précédents, c'est-à-dire que si alternativement le signal $X_1(t)$ est fort puis l'autre signal $X_2(t)$ l'est à son tour, l'estimation $\hat{X}_1(t)$ va apparaître non seulement sur la voie 1 (affectée au signal $X_1(t)$) mais aussi sur la voie 2. Et inversement lorsque le signal $X_2(t)$ devient fort.

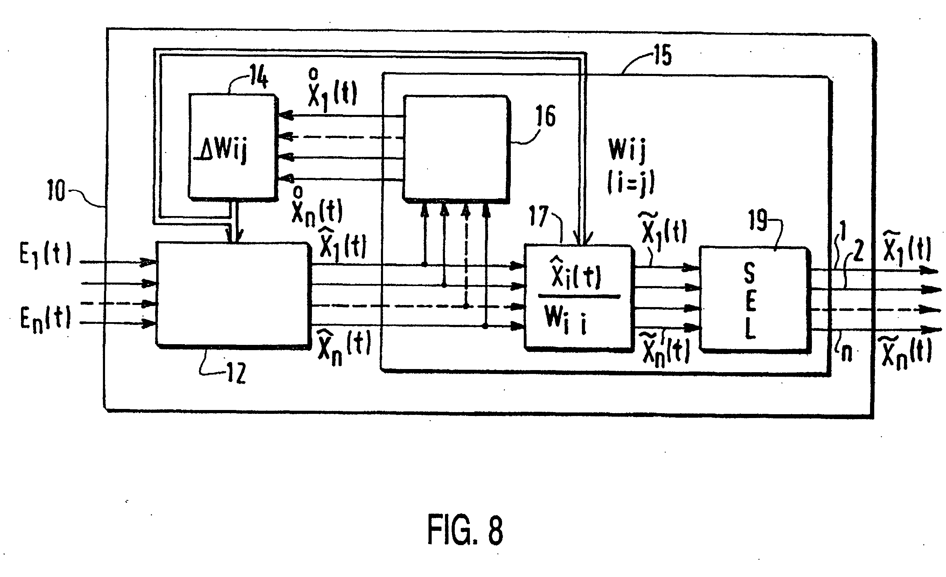

Pour traiter ce cas, le troisième sous-ensemble 15 dispose en sortie d'un module de sélection 19 qui empêche à une estimation d'être dupliquée sur une voie affectée à un signal de source absent. Le module de sélection 19 est connecté en sortie du module de sortie 17 (figure 7) de manière à obtenir le schéma représenté sur la figure 8. Ce module 19 opère de la manière suivante:

- si les deux signaux qui arrivent sur ses entrées sont corrélés, alors le module 19 délivre le signal qui a la plus forte amplitude et garde l'autre sortie à zéro.
- si les deux signaux ne sont pas corrélés, le traitement est effectué indépendamment du bloc comme cela a été décrit précédemment.

Pour mettre en oeuvre la fonction de ce module 19 il peut s'agir:

- d'un sous-bloc qui détecte la proportionnalité des deux signaux d'entrée de ce module 19, basée par exemple sur un test de corrélation qui active le multiplexage correct des signaux qui lui arrivent;
- ou d'un module de séparation de sources analogue à celui servant à la séparation de sources fourni dans la description ou à celui décrit dans le document de C. Jutten et J. Hérault cité précédemment. Mais dans ce cas, les signaux qui sont à traiter ne sont pas des signaux de mélanges "difficiles à traiter" car il s'agit à ce niveau de signaux qui sont soit corrélés, soit non corrélés.

Le cas avec deux signaux est donné à titre d'exemple, la sélection pouvant s'opérer entre plus de deux signaux.

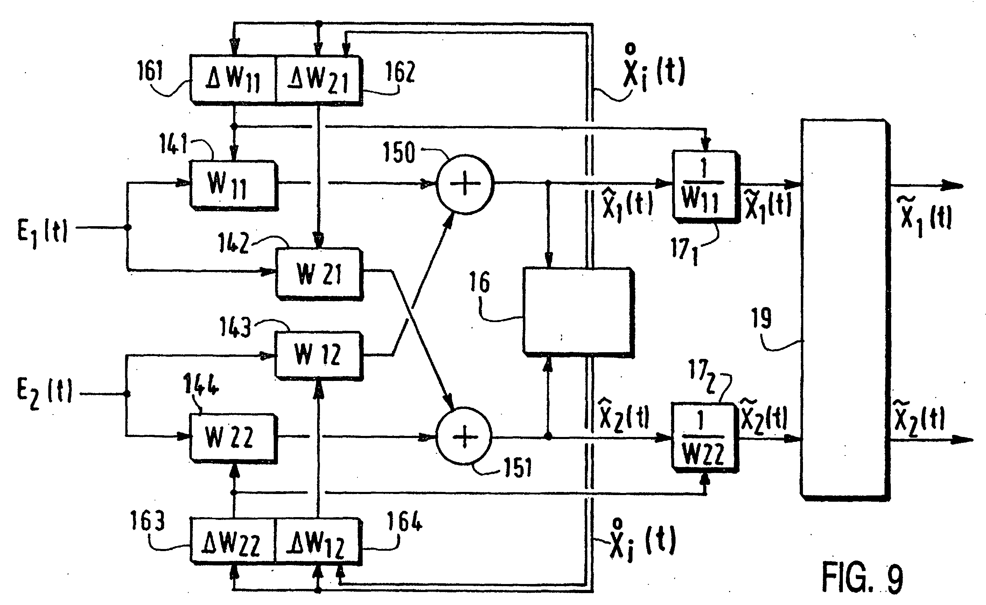

La figure 9 représente un mode particulier de réalisation de la figure 8 dans le cas où il n'existe que deux signaux de mélange $E_1(t)$ et $E_2(t)$. Les mêmes références sont utilisées pour la figure 9 et pour la figure 2. L'unité 16 de limitation d'amplitude délivre les estimations limitées $\dot{X}_1(t)$ et $\dot{X}_2(t)$ aux modules 161 à 164 qui calculent les nouveaux coefficients de séparation. Les sous-unités de sortie $17_1$ et $17_2$ calculent respectivement:

$$\tilde{X}_1(t) = \hat{X}_1(t) / W_{11}$$

et

$$\tilde{X}_2(t) = \hat{X}_2(t) / W_{22}.$$

Quand l'un des signaux $E_1(t)$ ou $E_2(t)$ est momentanément absent ou très faible, l'unité de sélection 19 fait que l'estimation de l'un ne soit pas dupliquée simultanément sur la voie qui ne lui est pas affectée.

## Revendications

1. Système de séparation de sources (10) pour traiter des signaux d'entrée (E(t)) formés par des mélanges de signaux primaires ($X_i(t)$) issus des sources (S1-Sn) et pour estimer les signaux primaires, le système comprenant un premier sous-ensemble (12) de séparation de sources ayant des premières entrées reliées aux signaux d'entrée, des secondes entrées pour recevoir des coefficients de séparation ($W_{ij}$) et des sorties pour délivrer des premières estimations ($\hat{X}_i(t)$ des signaux primaires, un second sous-ensemble (14) pour déterminer adaptativement les coefficients de séparation **caractérisé en ce qu'**il comprend un troisième sous-ensemble (15) qui reçoit les premières estimations parmi lesquelles il détecte une estimation maximale possédant un niveau d'amplitude maximal et qui normalise les premières estimations par rapport à l'estimation maximale pour délivrer des secondes estimations ($\dot{X}(t)$) lesquelles entrent dans le second sous-ensemble pour le calcul des coefficients de séparation.

2. Système selon la revendication 1 **caractérisé en ce que** le troisième sous-ensemble comporte un module de sortie (17) qui divise chaque première estimation ($\hat{X}_i(t)$) par un coefficient de séparation spécifique ($W_{ii}$) pour délivrer des troisièmes estimations ($\tilde{x}_i(t)$) proportionnelles aux signaux primaires avec des facteurs de proportionnalité respectifs indépendants desdits signaux primaires ($X_i(t)$).

3. Système selon une des revendications 1 ou 2 **caractérisé en ce que** le troisième sous-ensemble (15) dispose de voies de sortie (1-n) affectées spécifiquement à chaque estimation, le troisième sous-ensemble comportant un module de sélection (19) qui empêche à une estimation d'être dupliquée sur une voie affectée à un signal primaire absent.

4. Système selon une des revendications 1 à 3 **caractérisé en ce que** le second sous-ensemble (14) dispose de moyens de filtrage (141) pour filtrer les coefficients de séparation ($W_{ij}$).

## Patentansprüche

1. Trennvorrichtung für Quellen (10) zur Verarbeitung von Eingangssignalen (E(t)), gebildet aus primären, aus Quellen (S1-Sn) kommenden Signalmischungen ($X_i(t)$), und zur Bewertung der Primärsignale, wobei die Vorrichtung eine erste Untervorrichtung (12) zur Trennung von Quellen mit ersten Eingängen aufweist, die mit den Signaleingängen verbunden sind, zweite Eingänge für den Erhalt der Trennkoeffizienten ($W_{ij}$) sowie Ausgänge, um erste Be-

wertungen ($\dot{X}_i$(t)) der Primärsignale abzugeben, und eine zweite Untervorrichtung (14) zur adaptiven Bestimmung der Trennkoeffizienten, **dadurch gekennzeichnet, dass** sie eine dritte Untervorrichtung (15) aufweist, die die ersten Bewertungen erhält, unter denen sie eine maximale Bewertung mit einem maximalen Amplitudenniveau erkennt und welches die ersten Bewertungen in Bezug auf die maximale Bewertung normalisiert, um zweite Bewertungen ($\dot{X}$(t)) abzugeben, die zur Berechnung der Trennkoeffizienten in die zweite Untervorrichtung kommen.

2. Vorrichtung nach Anspruch 1, **dadurch gekennzeichnet, dass** die dritte Untervorrichtung ein Ausgangsmodul (17) enthält, das jede erste Bewertung ($\dot{X}_i$(t)) durch einen spezifischen Trennkoeffizienten ($W_{ii}$) teilt, um dritte Bewertungen ($\tilde{\mathcal{X}}_i$(t)) auszugeben, proportional zu den Primärsignalen mit von den besagten Primärsignalen unabhängigen Proportionalitätsfaktoren ($X_i$ (t)).

3. Vorrichtung nach einem der Ansprüche 1 oder 2, **dadurch gekennzeichnet, dass** die dritte Untervorrichtung (15) Ausgangswege (1-n) aufweist, die spezifisch jeder Bewertung zugeteilt sind, wobei die dritte Untervorrichtung über ein Auswahlmodul (19) verfügt, das eine Bewertung daran hindert, über einen einem abwesenden Quellsignal zugeteilten Weg dupliziert zu werden.

4. Vorrichtung nach einem der Ansprüche 1 bis 3, **dadurch gekennzeichnet, dass** die zweite Untervorrichtung (14) über Filterverfahren (141) verfügt, um die Trennkoeffizienten ($W_{ij}$) zu filtern.

**Claims**

1. A source separation system (10) for processing input signals (E(t)) formed by mixtures of primary signals ($X_i$(t)) originating from various sources (S1-Sn) and for estimating the primary signals, the system comprising a first source separation sub-assembly (12) which has first inputs connected to the input signals, second inputs for receiving separation coefficients ($W_{ij}$) and outputs for producing first estimates ($\dot{X}_i$ (t)) of the primary signals, a second sub-assembly (14) for adaptively determining the separation coefficients, **characterized in that** the source separation system (10) comprises a third sub-assembly (15) which receives the first estimates among which it detects a maximum estimate with a maximum amplitude level and which standardizes the first estimates relative to the maximum estimate to produce second estimates ($\dot{X}$(t)) which enter the second sub-assembly for the calculation of the separation coefficients.

2. The system as claimed in claim 1, **characterized in that** the third sub-assembly comprises an output module (17) which divides each first estimate ($\dot{X}_i$(t)) by a specific separation coefficient ($W_{ii}$) to produce third estimates ($\tilde{\mathcal{X}}_i$(t)) which are proportional to the primary signals with proportionality factors which are independent of said primary signals ($X_i$ (t)).

3. A system as claimed in one of the claims 1 or 2, **characterized in that** the third sub-assembly (15) has output channels (1-n) assigned specifically to each estimate, the third sub-assembly comprising a selection module (19) which prevents an estimate being duplicated on a channel assigned to a primary signal that is absent.

4. A system as claimed in one of the claims 1 to 3, **characterized in that** the second sub-assembly (14) has filter means (141) for filtering the separation coefficients ($W_{ij}$).

EP 0 860 944 B1

FIG. 1

FIG. 2

FIG. 3

FIG. 4

FIG. 5

FIG. 6

FIG. 7

FIG. 8

FIG. 9